(19) Europäisches Patentamt
European Patent Office
Office européen des brevets

(11) **EP 3 647 809 A1**

(12) **EUROPEAN PATENT APPLICATION**
published in accordance with Art. 153(4) EPC

(43) Date of publication:
**06.05.2020 Bulletin 2020/19**

(51) Int Cl.:
***G01S 7/38*** (2006.01)

(21) Application number: **17919386.7**

(22) Date of filing: **28.07.2017**

(86) International application number:
**PCT/JP2017/027448**

(87) International publication number:
**WO 2019/021459 (31.01.2019 Gazette 2019/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Mitsubishi Electric Corporation**
**Chiyoda-ku**
**Tokyo 100-8310 (JP)**

(72) Inventors:
• **YAMADA, Tetsutaro**
**Tokyo 100-8310 (JP)**
• **TAKAHASHI, Yoshiki**
**Tokyo 100-8310 (JP)**
• **HARADA, Tetsuji**
**Tokyo 100-8310 (JP)**
• **OBATA, Yasushi**
**Tokyo 100-8310 (JP)**

(74) Representative: **Pfenning, Meinig & Partner mbB**
**Patent- und Rechtsanwälte**
**Theresienhöhe 11a**
**80339 München (DE)**

(54) **RADIO-WAVE DETECTION DEVICE**

(57) A device incudes: a prediction unit (19) for predicting a feature amount that is likely to be extracted in the future by a feature amount extracting unit (12) using a prediction model of a feature amount; and a hypothesis generation unit (15) for generating a hypothesis that assumes a transmission source of a radio wave detected by a reception unit (11) using a plurality of feature amounts extracted by the feature amount extracting unit (12) and the feature amount predicted by the prediction unit (19).

FIG. 1

**Description**

TECHNICAL FIELD

The present invention relates to a radio-wave detection device for detecting a transmission source transmitting a radio wave.

BACKGROUND ART

Non-Patent Literature 1 below discloses a radio-wave detection device that detects a transmission source transmitting a radio wave by detecting the radio wave transmitted from the transmission source and on the basis of the feature amount of an observation signal indicating the detected radio wave.
This radio-wave detection device adopts a method called multiple hypothesis tracking (MHT) as a method of classifying pulses that are radio waves repeatedly transmitted from a plurality of transmission sources, for each of the transmission sources.

CITATION LIST

NON-PATENT LITERATURE

Non-Patent Literature 1: J. Liu, H. Meng, Y. Liu, and X. Wang, "Deinterleaving pulse trains in unconventional circumstances using multiple hypothesis tracking algorithm," Signal Process., vol.90, no.8, pp.2581-2593, 2010.

SUMMARY OF INVENTION

TECHNICAL PROBLEM

The MHT adopted by conventional radio-wave detection devices generates a hypothesis on the basis of the feature amount of pulses repeatedly transmitted from a transmission source. However, there is a disadvantage that in a case where there is an omission of detection, which is a situation where some of the pulses repeatedly transmitted from the transmission source are not detected, it is not possible to generate an accurate hypothesis, and thus a false detection of the transmission source transmitting the pulses occurs.
The present invention has been devised to solve the above-mentioned disadvantage, and it is an object of the present invention to obtain a radio-wave detection device capable of detecting a transmission source transmitting a radio wave even in a situation in which a part of the radio wave repeatedly transmitted from the transmission source is not detected.

SOLUTION TO PROBLEM

A radio-wave detection device according to the present invention includes: a reception unit for detecting a radio wave transmitted from a transmission source and outputting an observation signal indicating the detected radio wave; a feature amount extracting unit for extracting a feature amount of the observation signal each time the observation signal is output from the reception unit; a prediction unit for predicting a feature amount that is likely to be extracted in a future by the feature amount extracting unit using a prediction model of a feature amount; a hypothesis generation unit for generating a hypothesis that assumes a transmission source of the radio wave detected by the reception unit using a plurality of feature amounts extracted by the feature amount extracting unit and the feature amount predicted by the prediction unit; a distribution estimation unit for estimating a frequency distribution of the plurality of feature amounts extracted by the feature amount extracting unit; and a hypothesis evaluation unit for calculating a hypothesis reliability indicating a certainty of the hypothesis generated by the hypothesis generation unit from the plurality of feature amounts extracted by the feature amount extracting unit and the frequency distribution estimated by the distribution estimation unit, and a hypothesis selection unit selects a hypothesis having a relatively high hypothesis reliability calculated by the hypothesis evaluation unit from one or more hypotheses already generated by the hypothesis generation unit and detects the transmission source transmitting the radio wave detected by the reception unit on the basis of the selected hypothesis.

ADVANTAGEOUS EFFECTS OF INVENTION

According to the present invention, included are: a prediction unit for predicting the feature amount that is likely to be extracted in a future by a feature amount extracting unit using a prediction model of a feature amount; a hypothesis generation unit for generating a hypothesis that assumes a transmission source of a radio wave detected by a reception unit using a plurality of feature amounts extracted by the feature amount extracting unit and the feature amount predicted by the prediction unit; a distribution estimation unit for estimating a frequency distribution of the plurality of feature amounts extracted by the feature amount extracting unit; and a hypothesis evaluation unit for calculating a hypothesis reliability indicating the certainty of the hypothesis generated by the hypothesis generation unit from the plurality of feature amounts extracted by the feature amount extracting unit and the frequency distribution estimated by the distribution estimation unit, and a hypothesis selection unit selects a hypothesis having a relatively high hypothesis reliability calculated by the hypothesis evaluation unit from one or more hypotheses already generated by the hypothesis generation unit and detects the transmission source transmitting the radio wave detected by the reception unit on the basis of the selected hypothesis. Therefore, an effect is exerted that the transmission source transmitting the radio wave can be detected even in a situation in which a part of the radio wave repeatedly transmitted from the transmission source is not detected.

## BRIEF DESCRIPTION OF DRAWINGS

FIG. 1 is a configuration diagram illustrating a radio-wave detection device according to a first embodiment of the present invention.
FIG. 2 is a diagram illustrating a hardware configuration of the radio-wave detection device according to the first embodiment of the present invention.
FIG. 3 is a hardware configuration diagram of a computer in a case where components excluding a reception unit 11 of the radio-wave detection device are implemented by software, firmware, or the like.
FIG. 4 is a flowchart illustrating a processing procedure of the radio-wave detection device according to the first embodiment of the present invention.
FIG. 5 is an explanatory diagram illustrating a detection omission in which a part of pulses repeatedly transmitted from a transmission source is not detected.
FIG. 6 is an explanatory graph illustrating an exemplary frequency distribution of the PRI.
FIG. 7 is an explanatory graph illustrating an exemplary frequency distribution of feature amount estimated by a distribution estimation unit 14.
FIG. 8 is an explanatory diagram illustrating exemplary hypotheses generated by a hypothesis generation unit 15.
FIG. 9 is an explanatory diagram illustrating an exemplary hypothesis that does not include a feature amount of a second pulse.
FIG. 10 is an explanatory diagram illustrating a hypothesis that includes a predicted feature amount in the hypothesis illustrated in FIG. 9.

## DESCRIPTION OF EMBODIMENTS

To describe the present invention further in detail, an embodiment for carrying out the present invention will be described below with reference to the accompanying drawings.

First Embodiment

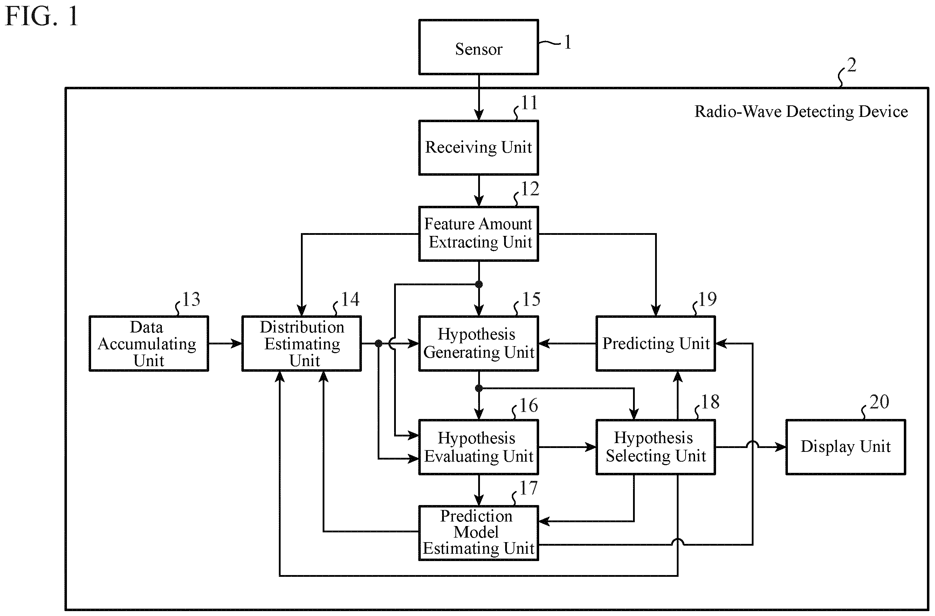

FIG. 1 is a configuration diagram illustrating a radio-wave detection device according to a first embodiment of the present invention.

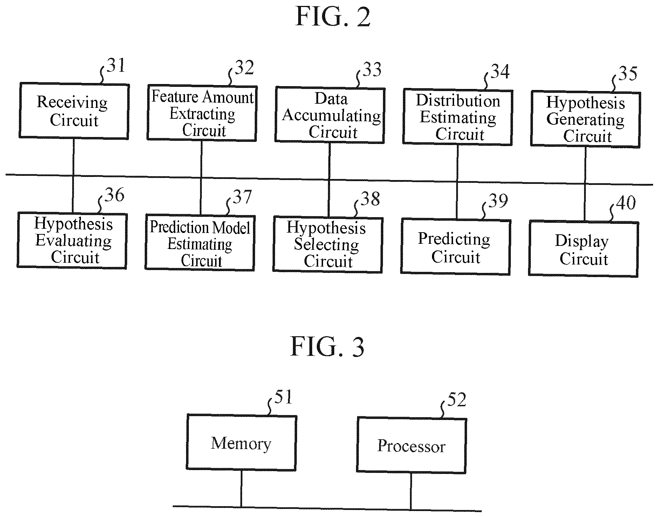

FIG. 2 is a diagram illustrating a hardware configuration of the radio-wave detection device according to the first embodiment of the present invention.
In FIGS. 1 and 2, a sensor 1 is a device, such as a radar, which receives a pulse that is a radio wave transmitted from a transmission source present in space.
The sensor 1 outputs the received pulse to a radio-wave detection device 2.
The radio-wave detection device 2 is a device for detecting a transmission source transmitting the pulse output from the sensor 1.
A reception unit 11 is implemented by, for example, a reception circuit 31 illustrated in FIG. 2.
The reception unit 11 detects the pulse output from the sensor 1.
The reception unit 11 converts an observation signal indicating the detected pulse from an analog signal into a digital signal, and outputs the digital observation signal to a feature amount extracting unit 12.
The feature amount extracting unit 12 is implemented by, for example, a feature amount extracting circuit 32 illustrated in FIG. 2.

Every time a digital observation signal is output from the reception unit 11, the feature amount extracting unit 12 performs processing of extracting the feature amount of the observation signal.

For example, the feature amount extracting unit 12 extracts the feature amount of an observation signal by performing processing for suppressing unwanted signals such as clutter, pulse detection processing, and angle measurement processing such as multiple signal classification (MUSIC) on the digital observation signal output from the reception unit 11.

A data accumulation unit 13 is implemented by, for example, a data accumulation circuit 33 illustrated in FIG. 2.

The data accumulation unit 13 stores information such as the average value and the variance value of the feature amounts of observation signal or the maximum target numbers as prior information.

A distribution estimation unit 14 is implemented by, for example, a distribution estimation circuit 34 illustrated in FIG. 2.

The distribution estimation unit 14 performs clustering of a plurality of feature amounts extracted by the feature amount extracting unit 12 using the appearance probability of a hidden variable output from a hypothesis selection unit 18 and the prior information stored by the data accumulation unit 13.

The distribution estimation unit 14 performs, for each class to which one or more feature amounts belong, processing of estimating the frequency distribution of the one or more feature amounts belonging to the class.

The appearance probability of a hidden variable output from the hypothesis selection unit 18 indicates from which transmission source the pulse detected by the reception unit 11 has been transmitted.

A hypothesis generation unit 15 is implemented by, for example, a hypothesis generation circuit 35 illustrated in FIG. 2.

The hypothesis generation unit 15 performs processing of generating a hypothesis that assumes a transmission source of the pulse detected by the reception unit 11 using the plurality of feature amounts extracted by the feature amount extracting unit 12.

Alternatively, in a case where a determination result of a prediction unit 19 indicates that the plurality of feature amounts extracted by the feature amount extracting unit 12 does not include any feature amount having a correlation with predicted feature amounts, the hypothesis generation unit 15 performs processing of generating a hypothesis that assumes a transmission source of the pulse detected by the reception unit 11 using the feature amounts predicted by the prediction unit 19.

In addition, the hypothesis generation unit 15 performs processing of generating a hypothesis using the frequency distributions of feature amount estimated by the distribution estimation unit 14.

A hypothesis evaluation unit 16 is implemented by, for example, a hypothesis evaluation circuit 36 illustrated in FIG. 2.

The hypothesis evaluation unit 16 performs processing of calculating the hypothesis reliability indicating the certainty of the hypotheses generated by the hypothesis generation unit 15 from the plurality of feature amounts extracted by the feature amount extracting unit 12 and the frequency distributions estimated by the distribution estimation unit 14.

A prediction model estimating unit 17 is implemented by, for example, a prediction model estimating circuit 37 illustrated in FIG. 2.

The prediction model estimating unit 17 performs processing of estimating a prediction model of a feature amount from a hypothesis selected by the hypothesis selection unit 18 and the hypothesis reliability calculated by the hypothesis evaluation unit 16.

The hypothesis selection unit 18 is implemented by, for example, a hypothesis selection circuit 38 illustrated in FIG. 2.

The hypothesis selection unit 18 selects a hypothesis having a relatively high hypothesis reliability calculated by the hypothesis evaluation unit 16 from among one or more hypotheses already generated by the hypothesis generation unit 15, and performs processing for detecting a transmission source transmitting the pulse detected by the reception unit 11 on the basis of the selected hypothesis.

The prediction unit 19 is implemented by, for example, the prediction circuit 39 illustrated in FIG. 2.

The prediction unit 19 performs processing of predicting a feature amount that is likely to be extracted by the feature amount extracting unit 12 in the future using the hypothesis selected by the hypothesis selection unit 18 and the prediction model of a feature amount estimated by the prediction model estimating unit 17 and outputting the predicted feature amount to the hypothesis generation unit 15.

The prediction unit 19 also performs processing of determining whether there is a correlation between the predicted feature amount and a feature amount extracted by the feature amount extracting unit 12 at each time point.

A display unit 20 is implemented by, for example, a display circuit 40 illustrated in FIG. 2.

The display unit 20 performs processing of displaying the detection result of the hypothesis selection unit 18 and other information on the display.

In FIG. 1, it is assumed that each of the reception unit 11, which is a component of the radio-wave detection device, the feature amount extracting unit 12, the data accumulation unit 13, the distribution estimation unit 14, the hypothesis generation unit 15, the hypothesis evaluation unit 16, the prediction model estimating unit 17, the hypothesis selection unit 18, the prediction unit 19, and the display unit 20 is implemented by dedicated hardware as illustrated in FIG. 2. That is, it is assumed that implementation is made by the reception circuit 31, the feature amount extracting circuit 32, the data accumulation circuit 33, the distribution estimation circuit 34, the hypothesis generation circuit 35, the hypothesis evaluation circuit 36, the prediction model estimating circuit 37, the hypothesis selection circuit 38, the prediction circuit 39, and the display circuit 40.

Here, the data accumulation circuit 33 corresponds to a nonvolatile or volatile semiconductor memory such as a random access memory (RAM), a read only memory (ROM), a flash memory, an erasable programmable read only memory (EPROM), or an electrically erasable programmable read only memory (EEPROM), a magnetic disc, a flexible disc, an optical disc, a compact disc, a mini disc, or a digital versatile disk (DVD).

Here, the reception circuit 31, the feature amount extracting circuit 32, the distribution estimation circuit 34, the hypothesis generation circuit 35, the hypothesis evaluation circuit 36, the prediction model estimating circuit 37, the hypothesis selection circuit 38, the prediction circuit 39, and the display circuit 40 correspond to a single circuit, a composite circuit, a programmed processor, a parallel-programmed processor, an application specific integrated circuit (ASIC), a field-programmable gate array (FPGA), or a combination thereof.

For example, the components of the radio-wave detection device excluding the reception unit 11 are not limited to those implemented by dedicated hardware, and the components of the radio-wave detection device excluding the reception unit 11 may be implemented by software, firmware, or a combination of software and firmware.

The software or the firmware is stored in a memory of a computer as a program. Here, a computer refers to hardware for executing the program and corresponds to, for example, a central processing unit (CPU), a central processing device, a processing device, an arithmetic device, a microprocessor, a microcomputer, a processor, or a digital signal processor (DSP).

FIG. 3 is a hardware configuration diagram of a computer in a case where components excluding the reception unit 11 of the radio-wave detection device are implemented by software, firmware, or the like.

In the case where the components of the radio-wave detection device excluding the reception unit 11 are implemented by software, firmware, or the like, it is only required that the data accumulation unit 13 be configured on a memory 51 of the computer, that programs for causing the computer to execute processing procedures of the feature amount extracting unit 12, the distribution estimation unit 14, the hypothesis generation unit 15, the hypothesis evaluation unit 16, the prediction model estimating unit 17, the hypothesis selection unit 18, the prediction unit 19, and the display unit 20 be stored in the memory 51, and that a processor 52 of the computer execute the programs stored in the memory 51.

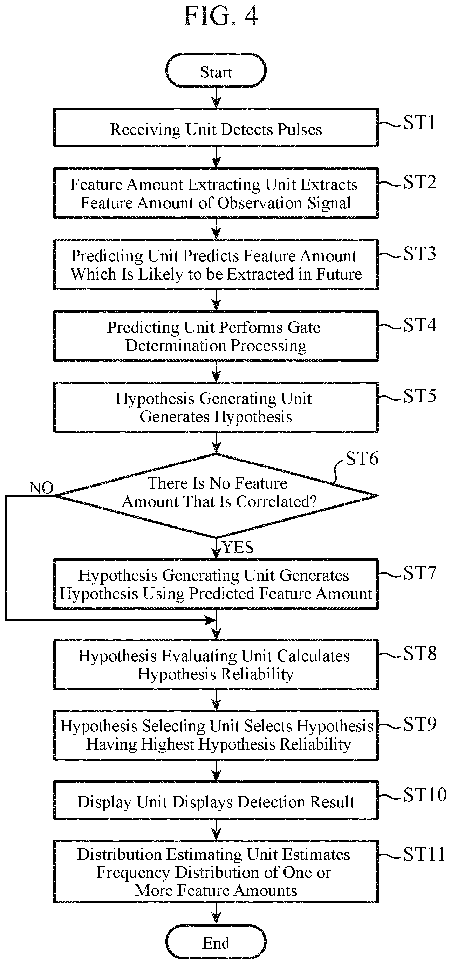

FIG. 4 is a flowchart illustrating a processing procedure of the radio-wave detection device according to the first embodiment of the present invention.

FIG. 2 illustrates the example in which each of the components of the radio-wave detection device is implemented by dedicated hardware, and FIG. 3 illustrates the example in which the components of the radio-wave detection device excluding the reception unit 11 are implemented by software, firmware, or the like; however, some of the components of the radio-wave detection device may be implemented by dedicated hardware with the rest of the components implemented by software, firmware, or the like.

Next, the operation will be described.

The sensor 1 receives each of pulses repeatedly transmitted from a transmission source present in space, and outputs each of the received pulses to the radio-wave detection device 2.

The reception unit 11 of the radio-wave detection device 2 detects the pulse each time a pulse is output from the sensor 1 (step ST1 in FIG. 4).

The reception unit 11 converts an observation signal indicating the detected pulse from an analog signal into a digital signal, and outputs the digital observation signal to a feature amount extracting unit 12.

The feature amount extracting unit 12 extracts a feature amount of the observation signal each time a digital observation signal is output from the reception unit 11 (step ST2 in FIG. 4).

Examples of the feature amount of the observation signal extracted by the feature amount extracting unit 12 include a value indicating the frequency, the azimuth, the pulse width, time of arrival (TOA), or the amplitude of the received pulse.

For example, the feature amount extracting unit 12 extracts a feature amount of the observation signal by performing processing for suppressing unwanted signals such as clutter, pulse detection processing, and angle measurement processing such as MUSIC on the digital observation signal output from the reception unit 11.

The feature amount extracting unit 12 outputs the feature amount of the extracted observation signal at each time point to the distribution estimation unit 14, the hypothesis generation unit 15, and the prediction unit 19.

The prediction unit 19 predicts a feature amount at each of a plurality of time points that is likely to be extracted in the future by the feature amount extracting unit 12 using one or more hypotheses output from the hypothesis selection unit 18 and the prediction model of a feature amount estimated by the prediction model estimating unit 17 (step ST3 in FIG. 4).

As the prediction processing of a feature amount by the prediction unit 19, for example, prediction processing performed in tracking processing of a transmission source using a known Kalman filter or MHT is conceivable.

The prediction process performed in the tracking processing is disclosed in the following Non-Patent Literature 2 and Non-Patent Literature 3 in addition to Non-Patent Literature 1 described above, and thus the details of the prediction processing of a feature amount by the prediction unit 19 are omitted.

[Non-Patent Literature 2] MANIWA Hisakazu, IWAMOTO Masafumi, KOBAYASHI Masaaki, and KIRIMOTO Tetsuo, "Deinterleaving of Radar Pulse Trains Using MHT Approach" IEICE Transactions on Communications, vol. J 84-B, no. 1, pp. 116-123, Jan. 2001

[Non-Patent Literature 3] S. Blackman, R. Popoli, Design and Analysis of Modern Tracking Systems, Artech House, 1999.

Next, the prediction unit 19 performs gate determination processing of determining whether there is a correlation between a predicted feature amount at each time point and a feature amount at each time point extracted by the feature amount extracting unit 12 (step ST4 in FIG. 4).

Hereinbelow, an example of the gate determination processing by the prediction unit 19 will be described.

First, the prediction unit 19 calculates a Mahalanobis distance or the like as a distance L between a predicted feature amount at each time point (hereinafter referred to as "predicted feature amount") and a feature amount extracted by the feature amount extracting unit 12 at each time point (hereinafter referred to as "extracted feature amount").

Next, the prediction unit 19 compares the distance L between a predicted feature amount at a certain time point and an extracted feature amount at the certain time point with a present distance threshold value $L_{th}$.

If the distance L is less than or equal to the distance threshold value $L_{th}$ as illustrated by the following inequation (1), the prediction unit 19 determines that there is a correlation between the predicted feature amount at the certain time point and the extracted feature amount at the certain time point.

$$L \leq L_{th} \rightarrow \text{There is a correlation.} \quad (1)$$

If the distance L is greater than the distance threshold value $L_{th}$ as illustrated by the following inequation (2), the prediction unit 19 determines that there is no correlation between the predicted feature amount at the certain time point and the extracted feature amount at the certain time point.

$$L > L_{th} \rightarrow \text{There is no correlation.} \quad (2)$$

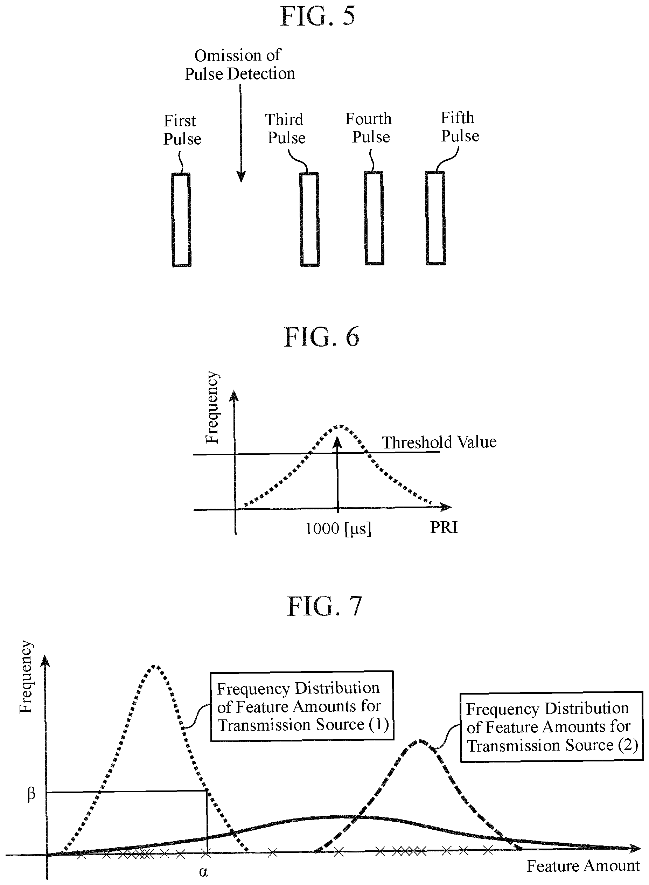

Here, FIG. 5 is an explanatory diagram illustrating a detection omission in which a part of pulses repeatedly transmitted from a transmission source is not detected.

The example of FIG. 5 illustrates a situation where pulses are transmitted from a transmission source at a constant pulse repetition interval (PRI), but a second pulse is not detected. The first and third to fifth pulses are detected.

Therefore, in the example of FIG. 5, feature amounts of the first and third to fifth pulses are extracted by the feature amount extracting unit 12; however, a feature amount of the second pulse is not extracted by the feature amount extracting unit 12.

For example, the distance L between a predicted feature amount for an i-th (i = 1, 3, 4, 5) pulse and an extracted feature amount for the i-th pulse extracted by the feature amount extracting unit 12 is likely to be less than or equal to the distance threshold value $L_{th}$, it is likely to be determined that there is a correlation.

However, a predicted feature amount for the second pulse does not have a corresponding extracted feature amount since no feature amount for the second pulse is extracted by the feature amount extracting unit 12. Therefore, for the predicted feature amount of the second pulse, a distance L to the extracted feature amount of the i-th pulse extracted by the feature amount extracting unit 12 is calculated.

Since the distance L between the predicted feature amount for the second pulse and the extracted feature amount for the i-th pulse extracted by the feature amount extracting unit 12 is likely to be larger than the distance threshold value $L_{th}$, it is likely to be determined that there is no correlation.

In the first embodiment, the example has been illustrated in which the prediction unit 19 predicts a feature amount at each of a plurality of time points that is likely to be extracted in the future by the feature amount extracting unit 12 using the hypothesis output from the hypothesis selection unit 18 and the prediction model of a feature amount estimated by the prediction model estimating unit 17.

This is merely an example, and the prediction unit 19 specifies the PRI of the pulses detected by the reception unit 11 with reference to distribution information indicating the frequency distribution of the PRI as illustrated in FIG. 6, for example.

Specifically, the prediction unit 19 specifies a PRI having the highest frequency and being greater than or equal to a threshold value as the PRI of pulses detected by the reception unit 11 with reference to the distribution information illustrated in FIG. 6. In the example of FIG. 6, 1000 [µs] is specified as the PRI of the pulses detected by the reception unit 11.

FIG. 6 is an explanatory graph illustrating an exemplary frequency distribution of the PRI.

The distribution information indicating the frequency distribution of the PRI is assumed to be held in the prediction unit 19 in advance, for example.

The prediction unit 19 predicts a feature amount at each time point determined by the specified PRI. In the example of FIG. 6, a feature amount for each of the pulses having a PRI of 1000 µs is predicted.

The hypothesis generation unit 15 generates a hypothesis that assumes a transmission source of the pulse detected by the reception unit 11 using the feature amounts of the respective time points extracted by the feature amount extracting unit 12 (step ST5 in FIG. 4).

For example, let us assume that a hypothesis (1) assuming that the pulses related to the feature amounts extracted by the feature amount extracting unit 12 are those transmitted from a transmission source (1) and a hypothesis (2) assuming that the pulses related to the feature amounts extracted by the feature amount extracting unit 12 are those transmitted from a transmission source (2) have already been generated.

In this case, the hypothesis generation unit 15 performs, for example as processing of generating a hypothesis, processing of including feature amounts newly extracted by the feature amount extracting unit 12 in the hypothesis (1) and processing of including feature amounts newly extracted by the feature amount extracting unit 12 in the hypothesis (2). In addition, the hypothesis generation unit 15 generates a hypothesis (3) assuming that the pulses are transmitted from a transmission source (3) and performs processing of including feature amounts newly extracted by the feature amount extracting unit 12 in the hypothesis (3).

Although the example has been illustrated here in which the hypothesis generation unit 15 generates three hypotheses, three hypotheses may be generated including a kinetic model for a transmission source having a fixed PRI for pulses to be transmitted, and three more hypotheses may be further generated that include a kinetic model for a transmission source having a variable PRI for pulses to be transmitted.

In this case, a total of six hypotheses are generated.

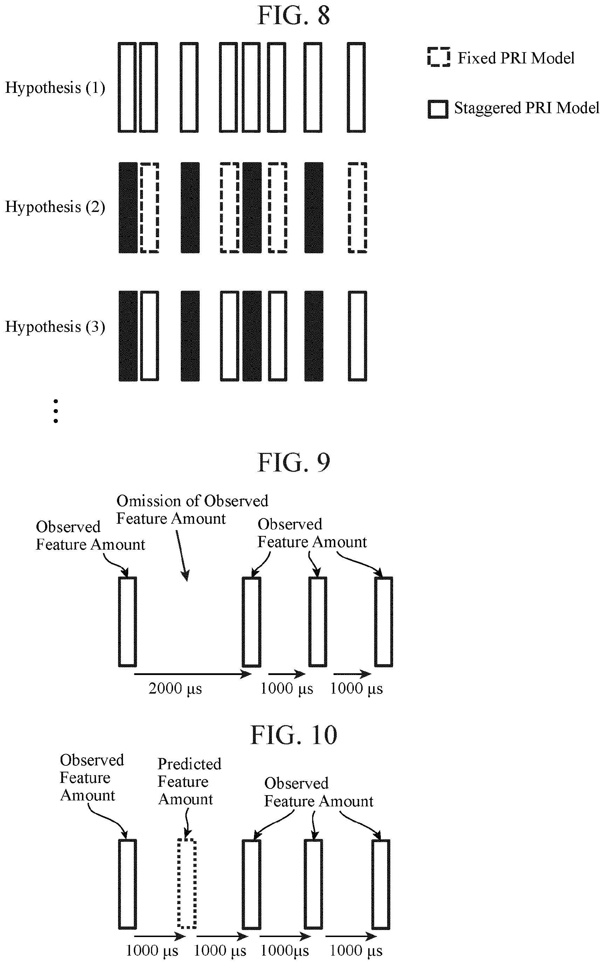

FIG. 8 is an explanatory diagram illustrating exemplary hypotheses generated by the hypothesis generation unit 15.

FIG. 8 illustrates exemplary hypotheses generated when eight pulses are detected by the reception unit 11.

In the example of FIG. 8, a solid pulse represents a pulse transmitted from the transmission source (1), and a blank pulse represents a pulse transmitted from the transmission source (2).

The hypothesis (2) illustrated in FIG. 8 includes a kinetic model for a transmission source having a fixed PRI for pulses to be transmitted, and the hypotheses (1) and (3) illustrated in FIG. 8 includes a kinetic model for a transmission source having a variable PRI for pulses to be transmitted.

The kinetic model for a transmission source having a fixed PRI is a fixed PRI model, and the kinetic model for a transmission source having a variable PRI is a staggered PRI model.

Although FIG. 8 illustrates the example in which the kinetic model for the transmission source in which the PRI varies is a staggered PRI model, no limitation is intended thereto. For example, a jitter PRI model may be adopted.

The example of FIG. 5 illustrates a situation in which the second pulse is not detected, and in this case no hypothesis including a feature amount for the second pulse is generated as illustrated in FIG. 8.

FIG. 9 is an explanatory diagram illustrating an exemplary hypothesis that does not include a feature amount of a second pulse.

The hypothesis illustrated in FIG. 9 is not an accurate hypothesis since no feature amount for the second pulse is included. Therefore, generating the incorrect hypothesis illustrated in FIG. 9 increases the probability of occurrence of false detection of the transmission source transmitting the pulses.

The hypothesis generation unit 15 further performs processing of generating a hypothesis as described below in order to reduce the probability of occurrence of false detection of the transmission source.

If the determination result of the prediction unit 19 indicates that the feature amounts at respective time points extracted by the feature amount extracting unit 12 include no feature amount correlated with the predicted feature amount (if YES in step ST6 in FIG. 4), the hypothesis generation unit 15 generates a hypothesis using the feature amount predicted by the prediction unit 19 (step ST7 in FIG. 4).

If the determination result of the prediction unit 19 indicates that the feature amounts at respective time points extracted by the feature amount extracting unit 12 include a feature amount correlated with the predicted feature amount (if NO in step ST6 in FIG. 4), the hypothesis generation unit 15 does not perform the processing of generating a hypothesis using the feature amount predicted by the prediction unit 19.

Hereinafter, the processing of generating a hypothesis by the hypothesis generation unit 15 will be specifically described.

The hypothesis generation unit 15 specifies a predicted feature amount that has no correlation with any of the extracted feature amounts extracted by the feature amount extracting unit 12 among the predicted feature amounts at the respective time points predicted by the prediction unit 19.

In the example of FIG. 9, since there is no extracted feature amount for the second pulse, the predicted feature amount for the second pulse is specified as a predicted feature amount that has no correlation with any of the extracted feature amounts.

The hypothesis generation unit 15 generates a hypothesis including the specified predicted feature amount and the feature amounts of the respective time points extracted by the feature amount extracting unit 12 as illustrated in FIG. 10.

FIG. 10 is an explanatory diagram illustrating a hypothesis that includes a predicted feature amount in the hypothesis illustrated in FIG. 9.

Since the feature amount for the second pulse is missing, without being extracted, in the example of FIG. 10, a hypothesis is generated using the predicted feature amount for the second pulse instead of the missing feature amount which was not extracted.

Here, an example is illustrated in which the hypothesis generation unit 15 specifies a predicted feature amount that has no correlation with any of the extracted feature amounts extracted by the feature amount extracting unit 12 among the predicted feature amounts at the respective time points predicted by the prediction unit 19. This is merely an example, and for example the hypothesis generation unit 15 may specify a predicted feature amount that has no correlation with any of the extracted feature amounts using the frequency distribution of feature amounts as illustrated in FIG. 7 estimated by the distribution estimation unit 14.

Specifically, the hypothesis generation unit 15 refers to the frequency distribution of feature amounts estimated by the distribution estimation unit 14 to specify each feature amount having a frequency greater than or equal to a threshold value.

Then, if there is a feature amount not extracted by the feature amount extracting unit 12 among the specified feature amounts having frequencies greater than or equal to the threshold value, the hypothesis generation unit 15 specifies the feature amount, which is not extracted by the feature amount extracting unit 12 and has a frequency greater than or equal to the threshold value, as a predicted feature amount that has no correlation with any of the extracted feature amounts.

The processing of estimating the frequency distribution of feature amounts by the distribution estimation unit 14 will be described later. The frequency distribution of feature amounts used by the hypothesis generation unit 15 is the frequency distribution estimated at a previous time point in step ST11 of FIG. 4.

FIG. 7 is an explanatory graph illustrating an exemplary frequency distribution of feature amount estimated by the distribution estimation unit 14.

FIG. 7 illustrates a frequency distribution of feature amounts belonging to the transmission source (1) as one class and a frequency distribution of feature amounts belonging to the transmission source (2) as another class.

The hypothesis evaluation unit 16 calculates the hypothesis reliability indicating the certainty of the hypotheses generated by the hypothesis generation unit 15 from the plurality of feature amounts extracted by the feature amount extracting unit 12 and the frequency distributions estimated by the distribution estimation unit 14 (step ST8 in FIG. 4).

The frequency distribution of feature amounts used by the hypothesis evaluation unit 16 is also the frequency distribution estimated at a previous time point in step ST 11 of FIG. 4.

The processing itself of calculating the hypothesis reliability by the hypothesis evaluation unit 16 is a known technique, and thus detailed description is omitted. For example, the hypothesis reliability can be calculated by the following approach.

The hypothesis evaluation unit 16 calculates the hypothesis reliability assuming that the variation of PRIs is small in feature amounts of pulses of a fixed PRI, whereas the variation of PRIs is large in feature amounts of pulses of a variable PRI such as staggered pulses or jitter pulses.

Specifically, in a case where the frequency distribution of the feature amounts for the transmission source (1) illustrated in FIG. 7 is used for example, the hypothesis evaluation unit 16 specifies, for example, a frequency $\beta$ corresponding to a feature amount $\alpha$ following the frequency distribution.

The hypothesis evaluation unit 16 specifies a frequency corresponding to each of the feature amounts for the transmission source (1) like the frequency $\beta$ corresponding to the feature amount $\alpha$, calculates the variation of PRIs of the feature amounts for the transmission source (1) from the identified frequencies, and calculates the hypothesis reliability from the variation of PRIs.

The prediction model estimating unit 17 estimates a prediction model of a feature amount from the hypothesis selected by the hypothesis selection unit 18 and the hypothesis reliability calculated by the hypothesis evaluation unit 16 and outputs the estimated model to the distribution estimation unit 14 and the prediction unit 19.

The processing of estimating a prediction model by the prediction model estimating unit 17 is a known technique disclosed in, for example, the above Non-Patent Literature 2, and thus detailed description will be omitted.

For example, in a case where the feature amount is TOA, a fixed PRI model, a staggered PRI model, a jitter PRI model, or the like can be handled as a prediction model of a feature amount. In a fixed PRI model, the PRI is estimated by the maximum likelihood method, and in a staggered PRIPRI model, the PRI, the position of the stagger, and the stagger ratio are estimated by the maximum likelihood method.

The processing of estimating a prediction model is processing of specifying, as a prediction model of a feature amount, a PRI model having the highest likelihood by calculating the likelihood of, for example, each of the fixed PRI model, the staggered PRI model, and the jitter PRI model using the hypothesis selected by the hypothesis selection unit 18 and the hypothesis reliability calculated by the hypothesis evaluation unit 16.

The hypothesis selection unit 18 selects a hypothesis having a relatively high hypothesis reliability calculated by the hypothesis evaluation unit 16 from among one or more hypotheses already generated by the hypothesis generation unit 15.

Specifically, the hypothesis selection unit 18 specifies top N hypotheses (where N is an integer greater than or equal to 1) having a high hypothesis reliability calculated by the hypothesis evaluation unit 16 from among one or more hypotheses already generated by the hypothesis generation unit 15.

The hypothesis selection unit 18 outputs the specified top N hypotheses to the prediction unit 19.

In addition, the hypothesis selection unit 18 normalizes the hypothesis reliabilities of the top N hypotheses in such a manner that the sum of hypothesis reliabilities in the top N hypotheses equals 1.

The hypothesis selection unit 18 calculates the appearance probability of a hidden variable from the top N hypotheses and the normalized hypothesis reliabilities. The processing itself of calculating the appearance probability of a hidden variable is a known technique, and thus detailed description will be omitted.

Furthermore, the hypothesis selection unit 18 selects a hypothesis having the highest normalized hypothesis reliability (hereinafter referred to as "the best hypothesis") from among the top N hypotheses (step ST9 in FIG. 4), and outputs the calculated appearance probability of a hidden variable to the distribution estimation unit 14 if the hypothesis reliability of the best hypothesis is greater than or equal to a specified value.

The hypothesis selection unit 18 further outputs, to the display unit 20, "the transmission source of the pulses detected by the reception unit 11" assumed by the best hypothesis as a detection result of the transmission source.

The display unit 20 displays the detection result and other information output from the hypothesis selection unit 18 on a display (step ST10 in FIG. 4).

Note that the hypothesis selection unit 18 prevents excessive number of hypotheses from being generated by erasing a hypothesis having a hypothesis reliability calculated by the hypothesis evaluation unit 16 less than or equal to the threshold value from among the one or more hypotheses already generated.

The distribution estimation unit 14 performs clustering of the feature amounts extracted by the feature amount extracting unit 12 using the appearance probability of a hidden variable output from the hypothesis selection unit 18 and the prior information stored by the data accumulation unit 13.

The distribution estimation unit 14 further estimates, for each class to which one or more feature amounts belong, a frequency distribution of the one or more feature amounts belonging to the class (step ST11 in FIG. 4).

The appearance probability of a hidden variable output from the hypothesis selection unit 18 indicates from which transmission source the pulse detected by the reception unit 11 has been transmitted.

As the processing of clustering feature amounts by the distribution estimation unit 14, for example, the known expectation maximization (EM) algorithm or the variational Bayesian algorithm disclosed in Non-Patent Literature 4 and Non-Patent Literature 5 below can be used.

In the case where the feature amount such as the frequency, the pulse width, the amplitude, and the azimuth of the radio wave pulses is used, the EM algorithm or the variational Bayesian algorithm using a contaminated normal distribution can be used for the processing of clustering the feature amounts.

By using the EM algorithm or the variational Bayesian algorithm, repeating an E step of calculating to which specifications the pulses belong and an M step of estimating the average value and the dispersion value of the frequency, the pulse width, the amplitude, and the azimuth, which are parameters of feature amounts of the pulses, enables estimation of the target to which the pulses belong and the frequency distribution of the feature amounts.

Moreover, in a case where the feature of the radio wave pulses is the TOA feature amount, repeating the E step of calculating to which specifications the pulses belong and an M step of estimating initial TOA and PRI, which are parameters of the TOA feature amount, using the known normal equation disclosed in Non-Patent Literature 5 below using a fixed PRI model with consideration to temporal changes in the TOA feature amount enables estimation of the target to which the pulses belong and the frequency distribution of the feature amounts.

[Non-Patent Literature 4] H. Attias: Learning parameters and structure of latent variable models by variational Bayes, Proc. Uncertainty in Artificial Intelligence (1999)

[Non-Patent Literature 5] C. M. Bishop: Pattern Recognition and Machine Learning, Springer (2006)

Specifically, the appearance probability of a hidden variable is calculated as the initial value of the M step by the following equation (3) from the reliability of a hypothesis.

In a case where a set of numbers of hypotheses that feature amount data $z_n$ belongs to a transmission source j is denoted by $C_{jn}$, and the hypothesis reliability of a hypothesis numbered j is denoted by $\beta_j$, an appearance probability of a hidden variable $\gamma_{in}$ in a case where the feature amount data $z_n$ belongs to a transmission source i is calculated by the following equation (3).

$$\gamma_{in} = \sum\nolimits_{j \in C_{in}} \beta_j \qquad (3)$$

The setting of the initial value for the appearance probability of a hidden variable is not limited to the above approach, and an initial value that maximizes the likelihood expressed by the following equation (12) may be selected by executing an approach of generating from uniform random numbers and the above approach in parallel and repeating, for each initial value, an E step and an M step described later.

In the M step, an average $\mu_{ij}$ which is a parameter of the contaminated normal distribution is calculated by the following equation (6) from the appearance probability of a hidden variable, a dispersion $\sigma_i$ which is a parameter of the contaminated normal distribution is calculated by the following equation (9), and the mixing ratio $\pi_k$ which is a parameter of the contaminated normal distribution is calculated by the following equation (10). The following equation (4) is a matrix having the appearance probability of a hidden variable as its diagonal elements, and the appearance probability of a hidden variable is set by the equation (3) at the first M step and the appearance probability of a hidden variable calculated in the step E described later is set by the following equation (11) in the second and subsequent M steps.

In the following equation (5), $W^i_{ML}$ denotes the weighting for the appearance probability of a hidden variable, and $\Phi$ denotes a normal matrix.

A symbol n denotes the number of pieces of accumulated feature amount data to be processed, $n_i$ denotes the number of pieces of feature amount data belonging to the transmission source i, and $z^i$ denotes a feature amount vector obtained by aligning $n_i \times 1$ pieces, that is $n_i$ pieces, of feature amount data belonging to the transmission source i. The feature amount data belonging to the transmission source i is feature amount data having the maximum appearance probability of a hidden variable for the transmission source i among K transmission sources.

A symbol hj represents a matrix representing a basis function. For example, in a case where only temporal primary changes in the feature amount are considered, the normal matrix $\Phi$ is expressed by the following equation (7), and the basis function hj is expressed by the following equation (8).

$$H_i = \begin{pmatrix} \gamma_{i1} & & & 0 \\ & \gamma_{i2} & & \\ & & \ddots & \\ 0 & & & \gamma_{in_i} \end{pmatrix} \qquad (4)$$

$$w^i{}_{ML} = (\Phi^T H_i \Phi)^{-1} \Phi^T H_i z^i \qquad (5)$$

$$\mu_{ij} = h_j{}^T w^i{}_{ML} \qquad (6)$$

$$\Phi = \begin{pmatrix} 1 & 1 \\ 1 & 2 \\ \vdots & \vdots \\ 1 & n_i \end{pmatrix} \qquad (7)$$

$$h_j = \begin{pmatrix} 1 \\ j \end{pmatrix} \qquad (8)$$

$$\sigma_i = \sqrt{\frac{1}{\sum_{j=1}^{n} \gamma_{ij}} (z - H_i w^j_{ML})^T H_i (z - H_i w^j_{ML})} \qquad (9)$$

$$\pi_k = \frac{1}{n_k} \sum_{j=1}^{n} \gamma_{kj} \qquad (10)$$

In the step E, the appearance probability of a hidden variable $\gamma_{ij}$ is re-estimated by the following equation (11) using the parameters obtained in the M step.

Here, K represents the number of transmission sources, and N (a; b, c) represents the probability that an observed value a appears from a normal distribution having an average b and a standard deviation c. Moreover in the step E, it may be determined that $\mu_{ij}$ is not correlated with the transmission source i using the gating processing described in Non-Patent Literature 3 in a case where the statistical distance between $\mu_{ij}$ and all feature amount data is greater than or equal to a certain value, and $\mu_{ij}$ may be removed from the feature amount data belonging to the transmission source i in a next M step.

Alternatively, using the global nearest neighbor (GNN) processing described in Non-Patent Literature 3, feature amount data $z_i$ having the smallest statistical distance from $\mu_{ij}$ may be used as feature amount data belonging to the transmission source i in the next M step using the $\mu_{ij}$ and $\sigma_i$ estimated in the M step. In addition, using the probabilistic data association (PDA) described in Non-Patent Literature 3, feature amount data belonging to the transmission source i in the next M step may be regenerated by weighting and integrating a plurality of pieces of feature amount data correlated with $\mu_{ij}$.

$$\gamma_{ij} = \frac{\pi_j N(z_i; \mu_{ij}, \sigma_i)}{\sum_{k=1}^{K} \pi_k N(z_i; \mu_{kj}, \sigma_k)} \qquad (11)$$

$$\log p = \sum_{j=1}^{n} \ln\{\sum_{k=1}^{K} \pi_k N(z_i; \mu_{kj}, \sigma_k)\} \qquad (12)$$

The processing is completed when the above-described M step and E step are repeated for a predetermined number of times, or when the variation of the parameters and the variation of the log likelihood function of equation (12) become smaller. A transmission source having the highest appearance probability of a hidden variable is regarded, for each piece of data, as the class to which the data belongs, and a contaminated normal distribution having the estimated parameters is regarded as the frequency distribution of the feature amounts.

As apparent from the above, according to the first embodiment, included are: the prediction unit 19 for predicting a feature amount that is extracted in the future by the feature amount extracting unit 12 using a prediction model of a feature amount; the hypothesis generation unit 15 for generating a hypothesis that assumes a transmission source of a radio wave detected by the reception unit 11 using a plurality of feature amounts extracted by the feature amount extracting unit 12 and the feature amount predicted by the prediction unit 19; the distribution estimation unit 14 for estimating a frequency distribution of the plurality of feature amounts extracted by the feature amount extracting unit 12; and the hypothesis evaluation unit 16 for calculating a hypothesis reliability indicating the certainty of the hypothesis generated by the hypothesis generation unit 15 from the plurality of feature amounts extracted by the feature amount extracting unit 12 and the frequency distribution estimated by the distribution estimation unit 14, and the hypothesis selection unit 18 selects a hypothesis having a relatively high hypothesis reliability calculated by the hypothesis evaluation unit 16 from one or more hypotheses already generated by the hypothesis generation unit 15 and detects the transmission source transmitting the radio wave detected by the reception unit 11 on the basis of the selected hypothesis. As a result, an effect is exerted that the transmission source transmitting a radio wave can be detected even in a situation in which a part of the radio wave repeatedly transmitted from the transmission source is not detected.

Note that the present invention may include modifications of any component of the embodiment, or omission of any component of the embodiment within the scope of the present invention.

INDUSTRIAL APPLICABILITY

The present invention is suitable for a radio-wave detection device for detecting a transmission source transmitting a radio wave.

REFERENCE SIGNS LIST

1: Sensor, 2:
Radio-wave detection device,
11: Reception unit,
12: Feature amount extracting unit,
13: Data accumulation unit,
14: Distribution estimation unit,
15: Hypothesis generation unit,
16: Hypothesis evaluation unit,
17: Prediction model estimating unit,
18: Hypothesis selection unit,
19: Prediction unit,
20: Display unit,
31: Reception circuit,
32: Feature amount extracting circuit,
33: Data accumulation circuit,
34: Distribution estimation circuit,
35: Hypothesis generation circuit,
36: Hypothesis evaluation circuit,
37: Prediction model estimating circuit,
38: Hypothesis selection circuit,
39: Prediction circuit,
40: Display circuit,
51: Memory, and
52: Processor.

**Claims**

1.  A radio-wave detection device comprising:

a reception unit for detecting a radio wave transmitted from a transmission source and outputting an observation signal indicating the detected radio wave;
a feature amount extracting unit for extracting a feature amount of the observation signal each time the observation signal is output from the reception unit;
a prediction unit for predicting a feature amount that is likely to be extracted in a future by the feature amount extracting unit using a prediction model of a feature amount;
a hypothesis generation unit for generating a hypothesis that assumes a transmission source of the radio wave detected by the reception unit using feature amounts extracted by the feature amount extracting unit and the feature amount predicted by the prediction unit;
a distribution estimation unit for estimating a frequency distribution of the feature amounts extracted by the feature amount extracting unit;
a hypothesis evaluation unit for calculating a hypothesis reliability indicating a certainty of the hypothesis generated by the hypothesis generation unit from the feature amounts extracted by the feature amount extracting unit and the frequency distribution estimated by the distribution estimation unit; and
a hypothesis selection unit for selecting a hypothesis having a relatively high hypothesis reliability calculated by the hypothesis evaluation unit from one or more hypotheses already generated by the hypothesis generation unit and detecting the transmission source transmitting the radio wave detected by the reception unit on a basis of the selected hypothesis.

**2.** The radio-wave detection device according to claim 1, wherein
the prediction unit predicts the feature amount that is likely to be extracted in the future by the feature amount extracting unit using the hypothesis selected by the hypothesis selection unit and the prediction model and determines whether there is a correlation between the predicted feature amount and each of the feature amounts extracted by the feature amount extracting unit, and
the hypothesis generation unit generates the hypothesis using the feature amounts extracted by the feature amount extracting unit and in a case where the determination result of the prediction unit indicates that the feature amounts extracted by the feature amount extracting unit includes no feature amount that is correlated with the predicted feature amount, generates a hypothesis using the feature amount predicted by the prediction unit.

**3.** The radio-wave detection device according to claim 1, wherein
the radio wave detected by the reception unit includes pulses, and
the prediction unit specifies a repetition interval of the pulses detected by the reception unit by referring to distribution information indicating a frequency distribution of the repetition interval of the pulses and predicts each of feature amounts at time points determined by the specified repetition interval.

**4.** The radio-wave detection device according to claim 1, wherein
the hypothesis generation unit generates the hypothesis using the frequency distribution estimated by the distribution estimation unit.

**5.** The radio-wave detection device according to claim 1, further comprising a prediction model estimating unit for estimating the prediction model from the hypothesis selected by the hypothesis selection unit and the hypothesis reliability calculated by the hypothesis evaluation unit.

**6.** The radio-wave detection device according to claim 1, wherein
the hypothesis generation unit erases a hypothesis, a hypothesis reliability of which calculated by the hypothesis evaluation unit is less than or equal to a threshold value, from among the one or more hypotheses already generated.

**7.** The radio-wave detection device according to claim 1, wherein
the radio wave detected by the reception unit includes pulses, and
the hypothesis generation unit generates a hypothesis on a transmission source having a fixed repetition interval of the pulses as well as a hypothesis on a transmission source having a variable repetition interval of the pulses.

**8.** The radio-wave detection device according to claim 1, wherein
the hypothesis selection unit calculates, on a basis of the selected hypothesis, an appearance probability of a hidden variable that is a probability indicating from which transmission source the radio wave transmitted from the transmission source has been transmitted, and
the distribution estimation unit performs clustering of the feature amounts extracted by the feature amount extracting unit using the appearance probability of a hidden variable calculated by the hypothesis selection unit and estimates, for each class to which one or more feature amounts belong, a frequency distribution of the one or more feature amounts belonging to the class.

**9.** The radio-wave detection device according to claim 1, wherein
the distribution estimation unit estimates the frequency distribution of the feature amounts extracted by the feature amount extracting unit in consideration of a temporal change in the feature amounts extracted by the feature amount extracting unit.

FIG. 1

# FIG. 2

| Receiving Circuit [31] | Feature Amount Extracting Circuit [32] | Data Accumulating Circuit [33] | Distribution Estimating Circuit [34] | Hypothesis Generating Circuit [35] |
|---|---|---|---|---|
| Hypothesis Evaluating Circuit [36] | Prediction Model Estimating Circuit [37] | Hypothesis Selecting Circuit [38] | Predicting Circuit [39] | Display Circuit [40] |

# FIG. 3

| Memory [51] | Processor [52] |
|---|---|

# FIG. 4

```
                    ( Start )
                        │
                        ▼
    ┌───────────────────────────────────────┐
    │      Receiving Unit Detects Pulses     │──ST1
    └───────────────────────────────────────┘
                        │
                        ▼
    ┌───────────────────────────────────────┐
    │  Feature Amount Extracting Unit Extracts│──ST2
    │   Feature Amount of Observation Signal  │
    └───────────────────────────────────────┘
                        │
                        ▼
    ┌───────────────────────────────────────┐
    │ Predicting Unit Predicts Feature Amount │──ST3
    │  Which Is Likely to be Extracted in Future│
    └───────────────────────────────────────┘
                        │
                        ▼
    ┌───────────────────────────────────────┐
    │      Predicting Unit Performs Gate      │──ST4
    │        Determination Processing         │
    └───────────────────────────────────────┘
                        │
                        ▼
    ┌───────────────────────────────────────┐
    │        Hypothesis Generating Unit       │──ST5
    │          Generates Hypothesis           │
    └───────────────────────────────────────┘
                        │
                        ▼
                   ╱──────────╲            ST6
      NO          ╱ There Is No Feature ╲
    ◄─────────────  Amount That Is Correlated?
                  ╲                    ╱
                   ╲──────────────────╱
                        │ YES
                        ▼
    ┌───────────────────────────────────────┐
    │  Hypothesis Generating Unit Generates   │──ST7
    │ Hypothesis Using Predicted Feature Amount│
    └───────────────────────────────────────┘
                        │
                        ▼
    ┌───────────────────────────────────────┐
    │   Hypothesis Evaluating Unit Calculates │──ST8
    │          Hypothesis Reliability         │
    └───────────────────────────────────────┘
                        │
                        ▼
    ┌───────────────────────────────────────┐
    │ Hypothesis Selecting Unit Selects Hypothesis│──ST9
    │    Having Highest Hypothesis Reliability │
    └───────────────────────────────────────┘
                        │
                        ▼
    ┌───────────────────────────────────────┐
    │    Display Unit Displays Detection Result│──ST10
    └───────────────────────────────────────┘
                        │
                        ▼
    ┌───────────────────────────────────────┐
    │  Distribution Estimating Unit Estimates │──ST11
    │    Frequency Distribution of One or     │
    │          More Feature Amounts           │
    └───────────────────────────────────────┘
                        │
                        ▼
                    ( End )
```

# FIG. 5

Omission of
Pulse Detection

First
Pulse

Third
Pulse

Fourth
Pulse

Fifth
Pulse

# FIG. 6

Frequency

Threshold Value

1000 [μs]        PRI

# FIG. 7

Frequency

β

Frequency Distribution
of Feature Amounts for
Transmission Source (1)

Frequency Distribution
of Feature Amounts for
Transmission Source (2)

α

Feature Amount

## FIG. 8

Hypothesis (1)

Hypothesis (2)

Hypothesis (3)

⋮

[: :] Fixed PRI Model

□ Staggered PRI Model

## FIG. 9

Omission of Observed
Feature Amount

Observed
Feature Amount

Observed
Feature Amount

2000 μs    1000 μs    1000 μs

## FIG. 10

Observed
Feature
Amount

Predicted
Feature
Amount

Observed
Feature Amount

1000 μs    1000 μs    1000μs    1000 μs

**INTERNATIONAL SEARCH REPORT**

| International application No. |
| --- |
| PCT/JP2017/027448 |

**A. CLASSIFICATION OF SUBJECT MATTER**
*G01S7/38(2006.01)i*

According to International Patent Classification (IPC) or to both national classification and IPC

**B. FIELDS SEARCHED**

Minimum documentation searched (classification system followed by classification symbols)
G01S7/38

Documentation searched other than minimum documentation to the extent that such documents are included in the fields searched
Jitsuyo Shinan Koho          1922-1996    Jitsuyo Shinan Toroku Koho    1996-2017
Kokai Jitsuyo Shinan Koho    1971-2017    Toroku Jitsuyo Shinan Koho    1994-2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y | Hisakazu MANIWA et al., "MHT deinterleaving method of pulse trains in consideration of false and miss detection", IEICE Technical Report, 20 April 2001 (20.04.2001), vol.101, no.33, pages 69 to 76, ISSN 0913-5685 | 1,3-9<br>2 |
| Y | Tetsutaro YAMADA et al., "Hybrid Multiple Hypotheses Tracking to Suppress Grating Lobe Observations in Separated Antenna Arrays", Proceedings of the 2016 IEICE General Conference, 01 March 2016 (01.03.2016), Tsushin 1, page 285, ISSN 1349-1369 | 2 |
| A | JP 10-82850 A  (Mitsubishi Electric Corp.), 31 March 1998 (31.03.1998), paragraphs [0032] to [0039] (Family: none) | 1-9 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered    to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>    11 October 2017 (11.10.17) | Date of mailing of the international search report<br>    24 October 2017 (24.10.17) |
| --- | --- |
| Name and mailing address of the ISA/<br>    Japan Patent Office<br>    3-4-3,Kasumigaseki,Chiyoda-ku,<br>    Tokyo 100-8915,Japan | Authorized officer<br><br>Telephone No. |

Form PCT/ISA/210 (second sheet) (January 2015)

**INTERNATIONAL SEARCH REPORT**

International application No.

PCT/JP2017/027448

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2003-215225 A  (Mitsubishi Electric Corp.), 30 July 2003 (30.07.2003), paragraphs [0072] to [0080] (Family: none) | 1-9 |
| A | JP 2008-256501 A  (Mitsubishi Electric Corp.), 23 October 2008 (23.10.2008), paragraphs [0004] to [0072] (Family: none) | 1-9 |
| A | JP 2006-234674 A  (Mitsubishi Electric Corp.), 07 September 2006 (07.09.2006), paragraphs [0029] to [0049] (Family: none) | 1-9 |
| A | JP 2006-177786 A  (Mitsubishi Electric Corp.), 06 July 2006 (06.07.2006), paragraphs [0008] to [0065] (Family: none) | 1-9 |
| A | JP 2000-266838 A  (Mitsubishi Electric Corp.), 29 September 2000 (29.09.2000), paragraphs [0002] to [0069] (Family: none) | 1-9 |
| A | US 5381150 A  (TRW INC.), 10 January 1995 (10.01.1995), entire text; all drawings (Family: none) | 1-9 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **J. LIU ; H. MENG ; Y. LIU ; X. WANG.** Deinterleaving pulse trains in unconventional circumstances using multiple hypothesis tracking algorithm. *Signal Process.,* 2010, vol. 90 (8), 2581-2593
- **MANIWA HISAKAZU ; IWAMOTO MASAFUMI ; KOBAYASHI MASAAKI ; KIRIMOTO TETSUO.** Deinterleaving of Radar Pulse Trains Using MHT Approach. *IEICE Transactions on Communications,* January 2001, vol. J 84-B (1), 116-123

- **S. BLACKMAN ; R. POPOLI.** Design and Analysis of Modern Tracking Systems. Artech House, 1999
- **H. ATTIAS.** Learning parameters and structure of latent variable models by variational Bayes. *Proc. Uncertainty in Artificial Intelligence,* 1999
- **C. M. BISHOP.** Pattern Recognition and Machine Learning. Springer, 2006